# FASCICULE DE BREVET EUROPEEN

(11) **EP 4 283 658 B1**
(45) Date de publication et mention de la délivrance du brevet: **29.01.2025**
(21) Numéro de dépôt: 23173762.8
(22) Date de dépôt: 16.05.2023
(51) Int. Cl.: H01L 21/18, H01L 21/02, H01L 21/20, H01L 21/762

(54) **PROCÉDÉ DE COLLAGE DIRECT ASSISTÉ PAR UNE MOLÉCULE BASIQUE**
VERFAHREN ZUM DIREKTEN BONDEN MIT HILFE EINES BASISCHEN MOLEKÜLS
METHOD FOR DIRECT BASIC MOLECULE ASSISTED BONDING

(30) Priorité: 25.05.2022 FR 2205052
(43) Date de publication de la demande: 29.11.2023
(73) Titulaire: Commissariat à l'Energie Atomique et aux Energies Alternatives, 75015 Paris (FR)
(72) Inventeur: FOURNEL, Frank, 38054 Grenoble Cedex 9 (FR); CALVEZ, Aziliz, 38054 Grenoble Cedex 9 (FR); LARREY, Vincent, 38054 Grenoble Cedex 9 (FR); MORALES, Christophe, 38054 Grenoble Cedex 9 (FR)
(74) Mandataire: Germain Maureau

(56) Documents cités:
- WO-A1-2021/084188
- US-A1- 2006 141 746
- US-A1- 2006 273 068

## Description

La présente invention se rapporte au domaine du collage direct. Elle concerne en particulier un procédé de fabrication d'une structure multicouche par collage direct.

Le collage direct est une technique maintenant bien connue et utilisée pour des applications industrielles comme la fabrication de SOI par la société SOITEC ou la société STMicroelectronics pour la production d'imageurs par exemple. Comme on l'entend dans le présent document, le collage direct est un collage spontané entre deux surfaces sans apport de matière à l'interface entre les surfaces collées, et notamment sans couche épaisse de liquide. Il est néanmoins possible d'avoir quelques monocouches d'eau adsorbées sur les surfaces, ce qui représente entre 0.25 nm et 1.25 nm d'épaisseur, de sorte que ces surfaces sont macroscopiquement sèches.

Le collage direct est classiquement réalisé à température ambiante et pression ambiante, mais ce n'est pas une obligation.

Une caractéristique importante du collage direct est son énergie d'adhésion, c'est-à-dire l'energie disponible pour réaliser le collage spontané. Il s'agit de l'énergie qui permet de déformer les deux surfaces pour les mettre en contact à l'echelle atomique afin que le forces de Van der Waals puissent être mises en œuvre. Cette énergie d'adhésion dirige en partie la durée de la propagation de l'onde de collage, par exemple l'onde de collage se propage de façon classique en 9 secondes pour le collage direct de deux substrats de silicium de 200 mm. Par exemple, pour deux surfaces de silicium ou d'oxyde de silicium hydrophile, l'énergie d'adhésion va typiquement de 30 à 100 mJ/m².

Une autre caractéristique importante du collage direct est son énergie d'adhérence ou autrement appelée son énergie de collage. C'est l'énergie qu'il faut utiliser pour séparer les deux surfaces collées. Dans le cadre du collage de deux substrats de silicium recouvert d'oxyde thermique d'environs 145 nm, cette adhérence varie typiquement entre 0.14J/m² et 6 J/m².

Pour obtenir un collage spontané, on nettoie généralement les surfaces des contaminations organiques et particulaires qui sont très préjudiciables au collage direct. Par exemple, le nettoyage est réalisé préalablement sur les surfaces à coller avec une solution à base d'acide Caro obtenue avec un mélange d'acide sulfurique 96% et d'eau oxygénée 30% (3 :1) à 180°C et de SC1 (mélange d'ammoniaque 30%, d'eau oxygénée 30% et d'eau déionisée (1 :1 :5)) à 70°C. Alternativement, il est possible d'utiliser d'autres solutions de nettoyage très oxydantes comme, par exemple, des solutions aqueuses contenant de l'ozone ou encore avec un traitement utilisant une exposition à une lumière UV en présence d'ozone gazeux. L'énergie d'adhérence d'un collage SiO₂-SiO₂ (deux substrats de silicium recouvert d'environ 145 nm d'oxyde thermique par exemple), dans une ambiance de salle blanche, avec un nettoyage chimique à base de Caro et de SC1 à 70°C, vaut environ 140mJ/m² juste après le collage, sans traitement thermique.

L'énergie de collage évolue également en fonction du traitement thermique que l'on applique après le collage réalisé à température ambiante. L'énergie d'adhérence augmente en fonction de la température des traitements thermiques. Par exemple, l'énergie de collage SiO₂-SiO₂ augmente lentement pour atteindre , suivant les traitements de surface, 3J/m² à 500°C et stagne ensuite jusqu'à 800°C.

Pour encore augmenter l'énergie de collage, un autre levier consiste à réaliser un traitement plasma préalablement à la mise en contact. Avec un plasma d'azote (N₂), pour un collage oxyde-oxyde, l'énergie de collage augmente rapidement à environs 5 J/m² pour une température de traitement de 300°C.

Cependant, l'utilisation d'un plasma peut être incompatible avec certains substrats et/ou son utilisation rallonge les temps et/ou coûts des procédés, ce qui les rend plus difficilement industrialisables. Le traitement plasma modifie aussi la surface sur une épaisseur de quelques nanomètres (entre 1 et 10 nm). Cette modification peut perturber les futurs dispositifs. Par exemple, avec une plaque de silicium, le plasma crée une couche d'oxyde qui est difficilement maîtrisable en terme d'épaisseur et de qualité. Avec une surface d'oxyde de silicium, certains plasmas comme le plasma N2 créént des problèmes de charges interfaciales pouvant perturber le fonctionnement électrique des futurs dispositifs.

Il a également été montré dans le brevet FR1912269 que l'exposition des surfaces Si et/ou SiO2 à une molécule spécifique comprenant un groupe fonctionnel hydrophile et un groupe fonctionnel basique, avant la mise en contact des deux surfaces lors du procédé de collage direct, apportait une augmentation significative de l'énergie d'adhérence de l'assemblage collé après un traitement thermique dans la gamme 100-500°C. L'exposition de la ou des surfaces avant collage peut se faire par voie liquide ou par voie gazeuse. D'autres antériorités pertinentes sont le document US 2006/273068 A1, qui décrit un procédé de liaison directe de deux substrats, comprenant, avant l'étape de liaison directe, une étape de traitement d'une surface oxydée de la première plaquette avec une solution de NH4OH/H2O2 pour augmenter la force de liaison ; et le document US 2006/141746 A1, qui décrit un procédé de liaison directe de deux substrats comprenant, avant l'étape de liaison directe, une étape d'activation d'au moins une des surfaces de liaison par application d'une solution d'activation comprenant une solution d'ammoniac (NH4OH) dans l'eau.

L'un des buts de la présente invention est de proposer une méthode de collage direct simple à mettre en œuvre et permettant de pallier aux inconvénients précités. A cet effet, la présente invention propose un procédé de fabrication d'une structure multicouche par collage direct entre un premier substrat et un second substrat, le procédé comprenant les étapes de :
a) fourniture d'un premier substrat et d'un second substrat comprenant respectivement une première surface de collage et une seconde surface de collage,
b) mise en contact de la première surface de collage et de la seconde surface de collage de sorte à créer une interface de collage direct entre le premier substrat et le second substrat,
c) disposition d'au moins l'interface de collage direct dans un environnement basique, et
d) application d'un traitement thermique à une température comprise entre 20°C et 1000°C, notamment entre 100°C et 500°C, par exemple entre 150 et 250°C, de sorte à obtenir la structure multicouche.

Ce procédé de collage direct ainsi réalisé permet d'obtenir une structure multicouche présentant une énergie de collage supérieure à celle d'une structure multicouche obtenue par un procédé de collage direct dépourvu de l'étape c) de traitement dans un environnement basique. Une forte énergie de collage est alors obtenue à basse température, c'est-à-dire à des températures inférieures à 1000°C, de préférence inférieure ou égale à 500°C et encore de préférence une température de 200°C.

Ces températures de collage sont compatibles avec de nombreuses applications et/ou avec de nombreux substrats, dont la nature et/ou la présence de composants électroniques et/ou opto-électroniques nécessitent de faibles budgets thermiques. De plus, le procédé est applicable à de nombreux matériaux et est peu coûteux. Le procédé conduit à des structures multicouches possédant une bonne tenue mécanique après collage, compatibles avec des procédés ultérieurs comme le Smart Cut^{™} et/ou tout procédé générant des contraintes mécaniques sur l'assemblage, comme par exemple un amincissement mécanique. De plus, ce procédé n'affecte pas l'énergie d'adhésion puisque l'utilisation d'un environnement basique n'est réalisée qu'après la mise en contact direct des surfaces. Par exemple, l'onde de collage se propage toujours en 9 secondes pour des substrats de silicium d'environ 200 mm.

Le traitement thermique post collage est également connu par l'homme de l'art sous la dénomination de 'recuit de collage'.

Selon une possibilité, le traitement thermique selon l'étape d) est réalisée par une montée en température, depuis la température ambiante jusqu'à une température finale, la montée en température étant réalisée avec une pente de 0.1 à 10°C/mn par exemple et plus spécifiquement de 0.5 à 5°C/mn pour ensuite atteindre un pallier d'une durée de quelques heures, par exemple 2 heures, à une température finale entre 200 et 300°C.

Selon une possibilité, l'étape c) de disposition de l'interface de collage direct dans un environnement basique est réalisée pendant une durée d'environ 1h à 80 jours. La durée de cette étape augmente avec le diamètre du premier et du deuxième substrat. Il est en effet nécessaire que les molécules basiques de l'environnement de l'étape c) aient le temps de se déplacer sur la totalité de l'interface de collage direct pour obtenir une énergie de collage homogène et uniforme Aussi, plus le diamètre de la structure multicouche est grand, plus la durée de l'étape c) est importante.

Selon une disposition, la première surface de collage et/ou la seconde surface de collage est formée au moins en partie par un film hydrophile en un matériau choisi parmi un oxyde natif, un oxyde de silicium thermique ou déposé, un nitrure de silicium, un oxyde de cuivre et une combinaison de ces matériaux.

Typiquement, le film hydrophile en oxyde de cuivre est un film hybride composé de plots de cuivre séparés par du SiO2. Les plots de cuivre se recouvrent quasi instantanément à l'air d'un oxyde de cuivre natif.

Lorsque le film hydrophile est en oxyde, il est par exemple formé par un oxyde déposé, un film mince d'oxyde obtenu par un traitement thermique (également appelé oxyde thermique) et/ou un mince film d'oxyde obtenu par un traitement chimique (également appelé oxyde natif ou oxyde chimique).

Selon une variante, le premier et/ou du second substrat sont en matériau(x) oxydé(s), tel que l'alumine, de sorte que la première surface de collage et/ou la seconde surface de collage sont formées par le matériau respectivement du premier et/ou du second substrat car il s'agit d'un matériau intrinsèquement hydrophile. Ceci n'interdit pas la présence d'un film hydrophile en complément.

Selon un exemple particulier, la première surface de collage est hydrophobe (par exemple en silicium hydrophobe obtenu par passivation de la surface du silicium et greffage d'hydrogène sur le silicium) et la seconde surface de collage est hydrophile. La seconde surface de collage est formée au moins en partie par un film hydrophile choisi parmi un oxyde natif (de silicium, d'AsGa, InP ... selon le matériau du second substrat), un oxyde thermique (de silicium), un oxyde déposé, un nitrure de silicium, un oxyde de cuivre et une combinaison de ces composés, ou bien la seconde surface de collage est constituée par le matériau du second substrat qui est un oxyde et donc hydrophile. La mise en contact de la seconde surface hydrophile avec la surface hydrophobe change le caractère initial hydrophobe de cette dernière en un caractère hydrophile ce qui permet le collage direct.

De manière concrète, la première surface de collage et la seconde surface de collage sont totalement planes. Autrement dit, la première et la seconde surface de collage sont dépourvues d'évidement ou de motifs formant des plateaux à l'échelle microscopique. La première surface de collage et/ou la seconde surface de collage présente une rugosité de l'ordre de l'angström RMS typiquement inférieure 5 angström RMS.

La première surface de collage et/ou la seconde surface de collage présente une rugosité pic - vallée inférieure à 5 nm.

Selon une possibilité, le premier substrat et le second substrat présentent un diamètre strictement supérieur à 2,5 cm.

De façon avantageuse, l'étape a) comprend en outre le séchage de la première surface de collage et de la seconde surface de collage avant de réaliser l'étape b) de mise en contact. A l'issu du séchage, la première surface de collage et la seconde surface de collage présentent chacune une face sur laquelle réside au plus une à cinq couches monoatomiques d'H₂O, de sorte que la première surface de collage et la seconde surface de collage sont sèches à l'échelle macroscopique.

De manière concrète, l'environnement basique est une solution basique aqueuse. Aussi l'étape c) consiste à immerger au moins l'interface de collage direct dans ladite solution basique aqueuse. Autrement dit, l'assemblage multicouche obtenu à l'étape b) est totalement ou partiellement immergé dans la solution basique aqueuse dans la mesure où l'interface de collage direct est immergée dans ladite solution basique.

Selon une disposition, la solution basique aqueuse présente un pH strictement supérieur à 7,5, notamment supérieur à 8 et par exemple supérieur à 9.

Selon une possibilité, la solution basique aqueuse est formée, par dissolution dans l'eau déionisée, d'un composé basique choisi parmi le NaOH, KOH, Na₂CO₃, NH₄OH, un aminoalcool et un mélange de ces composés; l'aminoalcool étant notamment sélectionné parmi le diméthylaminoéthanol (ou DMAE, CAS :108-01-0), la N,N-Diéthyl-2-amino-éthanol (ou DEAE, CAS : 100-37-8), la monoéthanolamine (CAS : 141-43-5), la N-méthyldiéthanolamine (ou MDEA, CAS : 105- 59-9), l'aminométhanol (CAS : 3088-27-5), la N-méthylhydroxylamine (CAS :593-77-1), la diéthanolamine (ou DEA, CAS : 111-42-2), la diméthanolamine (CAS : 7487-32-3), la triéthanolamine (CAS : 102-71-6), la triméthanolamine (CAS : 14002-32-5) et un mélange de ces aminoalcools.

Selon une caractéristique, la solution basique aqueuse présente une concentration molaire comprise 10⁻⁷ mol/I et 5 mol/l, notamment entre 10⁻⁻⁶ mol/I et 1 mol/l et en particulier entre à 0,01 mol/l et 0,5 mol/l en composé basique. Une faible quantité de base suffit pour assurer un collage fort ce qui permet une étape peu coûteuse. Bien entendu, une concentration molaire plus importante est possible mais sans amélioration sur les résultats obtenus.

Selon une alternative de réalisation, l'environnement basique est une atmosphère saturée de molécules basiques en phase vapeur par évaporation dans une enceinte hermétique d'une solution mère basique comprenant de l'eau déionisée et un composé basique choisi parmi la N,N-diéthyléthanolamine, la N,N-diméthyléthanolamine, le 2-aminoéthanol, N-méthyldiéthanolamine, l'aminométhanol, la N-méthylhydroxylamine, la diéthanolamine, la diméthanolamine, la triéthanolamine, la triméthanolamine, l'éthalonamine, le diéthyl-N-N-éthanol, l'ammoniaque et un mélange de ces composés.

Selon une possibilité, la solution mère basique comporte une concentration molaire comprise entre 10⁻⁷ mol/l et 5 mol/l d'un aminoalcool dissous dans l'eau déionisée. La solution mère basique est placée dans une enceinte hermétique pendant une heure de sorte à obtenir un environnement gazeux saturé en aminoalcool gazeux. L'assemblage multicouche obtenu à l'étape b) est ensuite disposé dans l'enceinte hermétique pour soumettre l'interface de collage direct à l'atmosphère saturée de molécules basiques en phase vapeur.

Selon une disposition, la température du traitement thermique appliqué à l'étape d) est comprise entre 20°C et 1000°C, en particulier entre 100°C et 500°C, en particulier entre 150°C et 250°C.

Selon une possibilité le premier substrat et le second substrat sont chacun formés par un matériau indépendemment choisi parmi les semi-conducteurs, tel que Si, Ge, InP, AsGa, SiC, GaN; le LNO (acronyme pour oxyde de nickel lanthane LaNiO3), le LTO (acronyme de titanate de lithium Li2TiO3) et leur combinaison.

Le premier substrat et le deuxième peuvent être de nature identique ou de nature différente.

Selon un exemple de réalisation particulier, le premier substrat et le second substrat fournis à l'étape a) comprennent chacun un substrat de silicium présentant un diamètre compris entre 25 mm et 300 mm, par exemple entre 100 et 300 mm et en particulier 200 mm ou 300 mm, et la première surface de collage et la seconde surface de collage sont chacune formées par un film d'oxyde de silicium,
l'étape c) comprend la disposition de l'interface de collage direct, obtenue à l'étape b), dans l'environnement basique sur une durée comprise entre 21 et 40 jours, en particulier 30 jours, l'environnement basique étant une solution basique aqueuse, formée par dissolution de NaOH et présentant une concentration molaire comprise entre 10⁻⁷ mol/I et 0.01 mol.l et en particulier une concentration molaire d'environ 10⁻³ mol/l, et
l'étape d) comprend l'application d'un traitement thermique à environ 300°C, de sorte à obtenir un collage direct entre le premier substrat et le second substrat présentant une énergie de collage supérieure à 5J/m².

L'énergie de collage est mesurée par exemple avec la méthode du double levier à déplacement imposée dans une atmosphère anhydre comme décrit dans l'article de F. Fournel, L. Continni, C. Morales, J. Da Fonseca, H. Moriceau, F. Rieutord, A. Barthelemy, and I. Radu, Journal of Applied Physics 111, 104907 (2012).

Selon une variante de réalisation, le premier substrat fourni l'étape a) comprend une ou plusieurs premières vignettes provenant du vignetage du premier substrat de sorte à obtenir un collage direct de l'une ou plusieurs premières vignettes au second substrat.

La première surface de collage est délimitée par la face exposée de l'une ou plusieurs premières vignettes.

Selon une autre variante, le second substrat fourni l'étape a) comprend une ou plusieurs secondes vignettes provenant du vignetage du second substrat de sorte à obtenir un collage direct entre l'une ou plusieurs premières vignettes et l'une ou plusieurs secondes vignettes.

La seconde surface de collage est délimitée par la face exposée de l'une ou plusieurs secondes vignettes.

Selon d'autres caractéristiques, le procédé de fabrication de la structure multicouche de l'invention comporte une ou plusieurs des caractéristiques optionnelles suivantes considérées seules ou en combinaison :
- Le premier substrat et/ou le second substrat présentent une épaisseur supérieure à 50 micromètres, de préférence supérieure à 100 micromètres, et par exemple une épaisseur d'environ 725 micromètres. Le premier substrat et/ou le second substrat peuvent être des couches suffisamment épaisses pour être autoportées.
- Le premier substrat et le second substrat sont des empilements d'au moins deux couches de matériau de nature différente.
- La première surface de collage et la seconde surface de collage respectivement du premier et du second substrat sont chacune formées au moins en partie par un film hydrophile en un oxyde natif, un oxyde de silicium, un nitrure de silicium, un oxyde de cuivre ou une combinaison de ces matériaux.
- La première surface de collage et/ou la seconde surface de collage respectivement du premier et du second substrat sont chacune totalement formées par un film hydrophile continu en un oxyde natif, un oxyde de silicium, un nitrure de silicium ou un oxyde de cuivre.
- Seule la première surface de collage ou la seconde surface de collage présente un caractère hydrophile avant la mise en contact.
- Le premier substrat et/ou le second substrat comprennent des évidements débouchant respectivement à la première et/ou la seconde surface de collage.
- La première surface de collage et la seconde surface de collage sont dépourvues de toute matière ajoutée avant la mise en contact à l'étape b).
- Le procédé comprend avant l'étape b) de mise en contact des surfaces de collage, une étape consistant à appliquer un traitement plasma sur les surfaces de collage des premier et second substrats. Il est ainsi possible de sensiblement diminuer la température du budget thermique tout en conservant une forte énergie de collage.
- Le séchage de la première surface de collage et de la seconde surface de collage comprend une centrifugation des premier et second substrats, en particulier à 2000 tours/min pendant 45 s.
- Le séchage de la première surface de collage et de la seconde surface de collage comprend un séchage utilisant l'effet Marangoni.
- La première surface de collage et/ou de la seconde surface de collage sont nettoyées par l'eau ozonée avant l'étape b).
- La première surface de collage et/ou de la seconde surface de collage sont nettoyées par un trainement SC1 et/ou un traitement SC2 avant l'étape b).
- La mise en contact selon l'étape b) est réalisée de préférence à température ambiante sous une atmosphère présentant une humidité relative d'environ 75% ou une valeur d'humidité inférieure ou sous vide (<5.10⁻²mbar) ou sous atmosphère anhydre (<0.5ppm).
- Le premier substrat et le second substrat fournis à l'étape a) comprennent chacun un substrat de silicium présentant un diamètre compris entre 50 mm et 300 mm, par exemple entre 100 mm et 200 mm, et la première surface de collage et la seconde surface de collage sont chacune formées par un film d'oxyde de silicium, l'étape c) comprend la disposition de l'interface de collage direct, obtenue à l'étape b), dans l'environnement basique sur une durée comprise entre 1 et 40 jours, en particulier l'environnement basique est une solution basique aqueuse de NaOH présentant une concentration molaire comprise entre 10⁻⁷ mol/l et 5 mol/l notamment entre 10⁻⁷ mol/I et 10⁻² mol/l et par exemple de 10⁻³ mol/l, et l'étape d) comprend l'application d'un traitement thermique à 300°C, de sorte à obtenir un collage direct entre le premier substrat et le second substrat, le collage direct présentant une énergie de collage supérieure à 5J/m².
- Le premier et le second substrat présentent un diamètre de 50 mm et la durée de l'étape c) est comprise entre environ 1 à 2 jours.
- Le premier et le second substrat présentent un diamètre de 100 mm et la durée de l'étape c) est comprise entre environ 4 à 6 jours.
- Le premier et le second substrat présentent un diamètre de 200 mm et la durée de l'étape c) est comprise entre environ 15 à 20 jours.
- L'étape c) de disposition d'au moins l'interface de collage direct est réalisée dans un environnement basique présentant une température comprise entre la température ambiante et 100°C à la pression atmosphérique et par exemple entre environ 50 °C et 60°C.
- Le premier et le second substrat présentent un diamètre de 300 mm et la durée de l'étape c) est comprise entre environ 35 à 40 jours.
- L'étape d) d'application du traitement thermique est réalisée de façon concomitante avec l'étape c).
- L'étape d) d'application du traitement thermique est réalisée au cours de l'étape c) sur une durée inférieure à celle de l'étape c).

D'autres aspects, buts et avantages de la présente invention apparaîtront mieux à la lecture de la description suivante de différentes variantes de réalisation de celle-ci, données à titre d'exemple non limitatif et faite en référence aux dessins annexés. Dans la suite de la description, par souci de simplification, des éléments identiques, similaires ou équivalents des différentes formes de réalisation portent les mêmes références numériques. Les figures ne respectent pas nécessairement l'échelle de tous les éléments représentés de sorte à améliorer leur lisibilité et dans lesquelles :
La figure 1 représente une vue schématique des étapes a) et b) du procédé selon un premier mode de réalisation de l'invention.
La figure 2 représente une vue schématique de l'étape c) du procédé selon le premier mode de réalisation de l'invention.
La figure 3 représente une vue schématique de l'étape d) du procédé selon le premier mode de réalisation de l'invention.
La figure 4 représente une vue schématique des étapes a) et b) du procédé selon un deuxième mode de réalisation de l'invention.
La figure 5 représente une vue schématique de l'étape c) du procédé selon le deuxième mode de réalisation de l'invention.
La figure 6 représente une vue schématique de l'étape d) du procédé selon le deuxième mode de réalisation de l'invention.
La figure 7 représente une vue schématique de l'étape c) du procédé selon une variante de réalisation de l'invention.

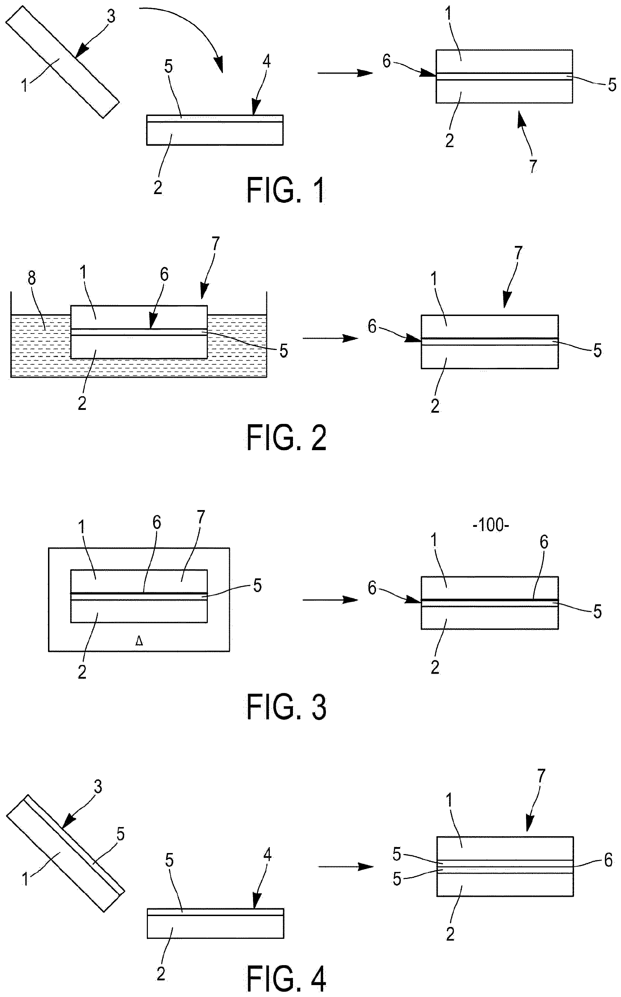

Comme illustré aux figures 1 à 3, le procédé de collage direct de la présente invention comprend les étapes de mise en contact d'un premier substrat 1 et d'un second substrat 2 (figure 1 étapes a et b), une étape de disposition dans un environnement basique, à savoir une solution aqueuse basique 8 dont le pH est strictement supérieur à 7,5 (figure 2 étape c) et une étape de traitement thermique de recuit de collage de sorte à obtenir une structure multicouche 100 présentant une énergie de collage plus importante que celle obtenue sans l'étape c) de disposition dans un environnement basique (figure 3 étape d). Les premier et second substrats 1,2 sont en silicium et présentent un diamètre de 200 mm et une épaisseur de 725 micromètres. Ces deux substrats 1,2 comprennent respectivement une première surface de collage 3 en un oxyde natif de silicium (non visible sur les figures) et une seconde surface de collage 4 formée en oxyde thermique de silicium (film hydrophile 5 d'oxyde de 145 nm d'épaisseur). Les première et seconde surfaces 3,4 sont préparées avant la mise en contact par un nettoyage à l'eau ozonée, au SC1 (mélange d'ammoniaque 30%, d'eau oxygénée 30% et d'eau déionisée dans les proportions volumiques respectives 1 : 1 : 5) suivi d'un SC2 (mélange d'acide chlorhydrique à 30%, d'eau oxygénée à 30% et d'eau dans les proportions volumiques respectives 1 : 1 : 5). Ces nettoyages permettent d'enlever les contaminations organiques et particulaires qui sont très préjudiciables au collage direct. Selon une variante non illustrée, l'étape de préparation des surfaces avant la mise en contact comprend un traitement plasma conventionnel.

Les première et seconde surfaces de collage 3, 4 sont ensuite mises en contact pour un collage direct spontané (étape b). L'interface de collage direct 6 de l'assemblage multicouche 7 ainsi obtenu est disposée dans un environnement basique constitué par une solution aqueuse basique 8 de NaOH dans l'eau déionisée de concentration molaire d'environ 10⁻³ mol/I (étape c).

L'immersion de l'assemblage multicouche 7 dans la solution aqueuse basique 8 est maintenue pendant 30 jours à l'issu desquels l'assemblage multicouche 7 est soumis à un traitement thermique de recuit de collage à 300°C (étape d- la montée en température depuis la température ambiante à 1°C/mn jusqu'à 300°C pendant 2 heures). La mesure de l'énergie de collage à la structure multicouche 100 obtenue conduit à la casse des substrats 1,2 de silicium et non au décollement des substrats 1,2. Ceci indique que l'énergie de collage obtenue est supérieure à 5J/m2 qui est l'énergie de rupture du silicium. Le même procédé réalisé sans l'étape c) d'immersion dans un environnement basique conduit à une énergie de collage de 4J/m2 après un recuit à 500°C.

Selon une alternative non illustrée, l'un des deux substrats 1,2 fournis à l'étape a) présente un plan de fragilisation. Le traitement thermique de recuit de collage participe au budget thermique permettant une fracture au niveau du plan de fragilisation. La structure multicouche 100 obtenue comprend alors l'un des deux substrats 1,2 collé à une couche mince transférée provenant de la fracture et un négatif de l'autre des substrats 1,2.

Selon une variante non illustrée, le temps d'immersion de l'interface de collage direct 6 dans l'environnement basique est d'environ 5 heures pour de substrats de 25 mm /l (15 jours pour des substrats de 200 mm de diamètre). La durée de l'immersion est également variable selon la nature des substrats 1,2.

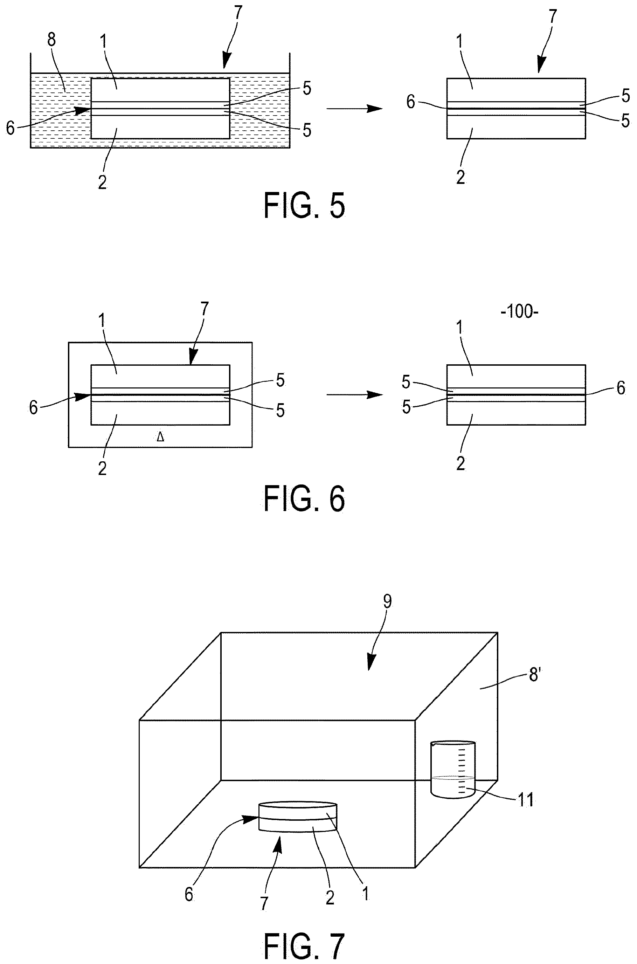

Comme illustré à la figure 4, un film d'oxyde de silicium 5 peut également former les surfaces de collage 3,4 des premier et deuxième substrats 1,2. La figure 4 illustre les deux surfaces de collages 3,4 mises en contact de sorte à former l'interface de collage direct 6. La figure 5 illustre l'étape c) du procédé qui consiste à disposer l'assemblage multicouche 7 obtenu à l'étape b) dans un environnement basique formé par une solution basique aqueuse 8 comprenant l'aminoalcool DMAE (acronyme du 2-(diméthylamino) éthanol) présentant une concentration molaire de 10⁻²mol/l. L'environnement basique 8 recouvre le niveau de l'interface de collage direct 6 et l'immersion est maintenue pendant 20 jours. Puis, le traitement thermique de renforcement de collage est appliqué à 200°C à l'assemblage multicouche 7 pendant 3 heures selon l'étape d) du procédé.

Ces opérations permettent d'obtenir une énergie de collage renforcée, notamment de plus de 5 J/m2 en tout point de l'interface de collage direct 6 (valeur obtenue en observant la rupture du silicium lors de l'application de la méthode du double levier). Lorsque le même procédé de collage direct est réalisé sans l'étape c), il est possible de séparer les premier et second substrats lors de l'application de la méthode du double levier.

Selon une variante de réalisation illustrée à la figure 7, l'assemblage 7 obtenu à l'étape b) est disposé dans un environnement basique formé par une atmosphère saturée de molécules basiques en phase vapeur 8'. A cet effet, le procédé prévoit la préparation d'une enceinte hermétique 9 saturée en molécules basiques en phase vapeur par évaporation d'une solution mère basique 11 d'éthalonamine présentant une concentration de 10⁻⁴ mol/I pendant une heure. Puis l'assemblage est placé dans l'enceinte 9 pendant deux fois plus de temps qu'avec une immersion (étape c). Après immersion de l'interface de collage direct 6 dans cette atmosphère saturée de molécules basiques en phase vapeur 8', l'assemblage 7 est soumis à un traitement thermique à 300°C pendant 2h (étape d) de renforcement de l'énergie de collage. A l'issue, l'énergie de collage mesurée par la méthode du double levier est supérieure à 5 J/m².

Selon une autre possibilité non illustrée, les deux surfaces de collages 3,4 sont traitées par plasma avant la mise en contact selon l'étape b) du procédé et le recuit thermique selon l'étape d) est appliqué à une température comprise entre environ 20 et 250°C, par exemple à 50°C, pendant quelques heures.

Selon une variante non illustrée sur les figures, les premier et/ou second substrats 1 et 2 sont en matériau choisi parmi le Ge, InP, AsGa, SiC, GaN, qui présentent une surface de collage en un film hydrophile tel qu'un oxyde natif du matériau considéré, LNO et LTO qui présentent intrinsèquement une surface de collage hydrophile.

Selon encore une autre variante non illustrée le premier substrat 1 fourni à l'étape a) est vigneté en plusieurs premières vignettes dont les faces exposées sont de premières surfaces de collage 3. Les premières vignettes sont collées selon le procédé précédemment décrit sur le seconde substrat 2 (pleine plaque) selon un collage puce-plaque également connu dans la terminologie anglo-saxonne par l'expression 'chip to wafer'. Selon encore une autre variante non illustrée, le second substrat 2 est également vigneté en plusieurs secondes vignettes et le procédé de l'invention permet le collage direct des premières vignettes et des secondes vignettes.

Selon une alternative non illustrée, la première surface de collage 3 et la seconde surface de collage 4 sont préparées de sorte à avoir des surfaces hybrides cuivre-oxyde collables en collage direct. Ces première et seconde surfaces de collage hydrophiles 3,4 sont typiquement composées de plots de cuivre de 2.5 micromètres de côté séparés par 2.5 micromètres de SiO2. On parle alors d'une surface hybride au « pitch » de 5 micromètres. Puis les étape b) à d) du procédé sont reproduites telles que précédemment décrites.

Ainsi, la présente invention propose un procédé de fabrication d'une structure multicouche 100 comportant un collage direct entre deux substrats 1,2 présentant une forte énergie de collage, et permettant de limiter la température du recuit thermique post collage. La préparation d'un environnement basique est peu coûteuse et l'étape d'immersion c) est applicable à de nombreux matériaux. Il est notamment possible de coller des substrats (ou couches épaisses) de matériaux ayant une différence significative de coefficient de dilatation thermique. De plus, lorsque les matériaux des premier et second substrats 1,2 comportent des dispositifs, ceux-ci ne sont pas endommagés par les températures utilisées.

Il va de soi que l'invention n'est pas limitée aux variantes de réalisation décrites ci-dessus à titre d'exemple mais que la portée de l'invention est définie par les revendications ci-jointes.

## Revendications

1. Procédé de fabrication d'une structure multicouche (100) par collage direct entre un premier substrat (1) et un second substrat (2), le procédé comprenant les étapes de :
a) fourniture d'un premier substrat (1) et d'un second substrat (2) comprenant respectivement une première surface de collage (3) et une seconde surface de collage (4),
b) mise en contact de la première surface de collage (3) et de la seconde surface de collage (4) de sorte à créer une interface de collage direct (6) entre le premier substrat (1) et le second substrat (2),
c) disposition d'au moins l'interface de collage direct (6) dans un environnement basique, et
d) application d'un traitement thermique à une température comprise entre 20°C et 1000°C de sorte à obtenir la structure multicouche (100).

2. Procédé de fabrication selon la revendication 1, dans lequel l'étape c) de disposition de l'interface de collage direct (6) dans l'environnement basique est réalisée pendant une durée d'environ 1 heure à 80 jours.

3. Procédé de fabrication selon la revendication 1 ou 2, dans lequel la première surface de collage (3) et/ou la seconde surface de collage (4) est formée au moins en partie par un film hydrophile (5) en un matériau choisi parmi un oxyde natif, un oxyde de silicium thermique ou déposé, un nitrure de silicium, un oxyde de cuivre et une combinaison de ces matériaux.

4. Procédé de fabrication selon l'une des revendications 1 à 3, dans lequel la première surface de collage (3) et la seconde surface de collage (4) sont totalement planes.

5. Procédé de fabrication selon l'une des revendications 1 à 4, dans lequel l'environnement basique est une solution basique aqueuse (8).

6. Procédé de fabrication selon la revendication 5, dans lequel la solution basique aqueuse (8) est formée, par dissolution dans l'eau déionisée, d'un composé basique choisi parmi le NaOH, KOH, Na₂CO₃, NH₄OH, un aminoalcool et un mélange de ces composés basiques; l'aminoalcool étant notamment sélectionné parmi la 2-(diméthylamino)éthanol DMAE, la N,N-diéthyl-2-amino-éthanol, la monoéthanolamine, la N-méthyldiéthanolamine, l'aminométhanol, la N-méthylhydroxylamine, la diéthanolamine, la diméthanolamine, la triéthanolamine, la triméthanolamine et un mélange de ces aminoalcools.

7. Procédé de fabrication selon la revendication 5 ou 6, dans lequel la solution basique aqueuse (8) présente une concentration molaire comprise entre 10⁻⁷ mol/l et 5 mol/l, notamment entre 10⁻⁻⁶ mol/l et 1 mol/l et en particulier entre à 0,01 mol/l et 0,5 mol/l en composé basique.

8. Procédé de fabrication selon l'une des revendications 1 à 4, dans lequel l'environnement basique est une atmosphère saturée de molécules basiques en phase vapeur (8'), par évaporation dans une enceinte hermétique (9) d'une solution mère basique (11) comprenant de l'eau déionisée et d'un composé basique choisi parmi la N,N-diéthyléthanolamine, diméthylaminoéthanol, le aminoéthanol, N-méthyldiéthanolamine, l'aminométhanol, la N-méthylhydroxylamine, la diéthanolamine, la diméthanolamine, la triéthanolamine, la triméthanolamine, l'éthalonamine, le diéthyl-N-N-éthanol, l'ammoniaque et leur combinaison.

9. Procédé de fabrication selon l'une des revendications 1 à 8, dans lequel le premier substrat (1) et le second substrat (2) sont chacun formés par un matériau choisi parmi des semi-conducteurs, tel que Si, Ge, InP, AsGa, SiC et GaN; le LNO, le LTO et leur combinaison.

10. Procédé de fabrication selon l'une des revendications 1 à 9, dans lequel :
le premier substrat (1) et le second substrat (2) fournis à l'étape a) comprennent chacun un substrat de silicium présentant un diamètre compris entre 25 mm et 300 mm, en particulier 200 mm ou 300 mm, et dans lequel la première surface de collage (3) et la seconde surface de collage (4) sont chacune totalement formées par un film hydrophile (5) continu d'oxyde de silicium,
l'étape c) comprend la disposition de l'interface de collage direct (6), obtenue à l'étape b), dans l'environnement basique sur une durée comprise entre 21 et 40 jours, l'environnement basique étant une solution basique aqueuse (8) formée par dissolution de NaOH et présentant une concentration molaire comprise entre 10⁻⁷ mol/l et 0.01 mol/l et par exemple une concentration molaire d'environ 10⁻³ mol/l, et
l'étape d) comprend l'application d'un traitement thermique à environ 300°C, de sorte à obtenir un collage direct entre le premier substrat (1) et le second substrat (2) présentant une énergie de collage supérieure à 5J/m².

## Patentansprüche

1. Verfahren zum Herstellen einer Mehrschichtstruktur (100) durch Direktverkleben zwischen einem ersten Substrat (1) und einem zweiten Substrat (2), wobei das Verfahren die Schritte umfasst zum:
a) Bereitstellen eines ersten Substrats (1) und eines zweiten Substrats (2) die jeweils eine erste Klebeoberfläche (3) und eine zweite Klebeoberfläche (4) umfassen,
b) In Kontakt bringen der ersten Klebeoberfläche (3) und der zweiten Klebeoberfläche (4), um eine Direktklebeschnittstelle (6) zwischen dem ersten Substrat (1) und dem zweiten Substrat (2) zu schaffen,
c) Anordnen von mindestens der Direktklebeschnittstelle (6) in einer basischen Umgebung, und
d) Anwenden einer Wärmebehandlung bei einer Temperatur, die zwischen 20°C und 1000°C liegt, um die Mehrschichtstruktur (100) zu erhalten.

2. Verfahren zum Herstellen nach Anspruch 1, wobei der Schritt c) zum Anordnen der Direktklebeschnittstelle (6) in der basischen Umgebung für eine Dauer von etwa 1 Stunde bis 80 Tagen durchgeführt wird.

3. Verfahren zum Herstellen nach Anspruch 1 oder 2, wobei die erste Klebeoberfläche (3) und/oder die zweite Klebeoberfläche (4) mindestens teilweise durch eine hydrophile Folie (5) aus einem Werkstoff gebildet wird, der aus einem nativen Oxid, einem thermischen oder abgeschiedenen Siliziumoxid, einem Siliziumnitrid, einem Kupferoxid und einer Kombination dieser Werkstoffe ausgewählt ist.

4. Verfahren zum Herstellen nach einem der Ansprüche 1 bis 3, wobei die erste Klebeoberfläche (3) und die zweite Klebeoberfläche (4) vollkommen eben sind.

5. Verfahren zum Herstellen nach einem der Ansprüche 1 bis 4, wobei die basische Umgebung eine wässrige basische Lösung (8) ist.

6. Verfahren zum Herstellen nach Anspruch 5, wobei die wässrige basische Lösung (8) durch Auflösen in entionisiertem Wasser einer basischen Verbindung gebildet ist, die ausgewählt ist aus NaOH, KOH, Na₂CO₃, NH₄OH, einem Aminoalkohol und einem Gemisch dieser basischen Verbindungen; wobei der Aminoalkohol insbesondere ausgewählt ist aus 2-(Dimethylamino)ethanol DMAE, N,N-Diethyl-2-amino-ethanol, Monoethanolamin, N-Methyldiethanolamin, Aminomethanol, N-Methylhydroxylamin, Diethanolamin, Dimethanolamin, Triethanolamin, Trimethanolamin und einem Gemisch dieser Aminoalkohole.

7. Verfahren zum Herstellen nach Anspruch 5 oder 6, wobei die wässrige basische Lösung (8) eine Molkonzentration aufweist, die zwischen 10⁻⁷ Mol/l und 5 Mol/l, insbesondere zwischen 10⁻⁻⁶ Mol/l und 1 Mol/l und insbesondere zwischen 0,01 Mol/l und 0,5 Mol/l an basischer Verbindung liegt.

8. Verfahren zum Herstellen nach einem der Ansprüche 1 bis 4, wobei die basische Umgebung eine gesättigte Atmosphäre an basischen Molekülen in einer Dampfphase (8') durch Verdampfen in einem hermetisch abgedichteten Gehäuse (9) einer basischen Stammlösung (11) ist, die entionisiertes Wasser und eine basische Verbindung umfasst, ausgewählt aus N,N-Diethylethanolamin, Dimethylaminoethanol, Aminoethanol, N-Methyldiethanolamin, Aminomethanol, N-Methylhydroxylamin, Diethanolamin, Dimethanolamin, Triethanolamin, Trimethanolamin, Ethalonamin, Diethyl-N-N-Ethanol, Ammoniak und deren Kombination.

9. Verfahren zum Herstellen nach einem der Ansprüche 1 bis 8, wobei das erste Substrat (1) und das zweite Substrat (2) jeweils durch einen Werkstoff gebildet sind, ausgewählt aus Halbleitern wie Si, Ge, InP, AsGa, SiC und GaN; LNO, LTO und deren Kombination.

10. Verfahren zum Herstellen nach einem der Ansprüche 1 bis 9, wobei:
das im Schritt a) bereitgestellte erste Substrat (1) und das zweite Substrat (2) jeweils ein Siliziumsubstrat umfassen, das einen Durchmesser aufweist, der zwischen 25 mm und 300 mm liegt, insbesondere 200 mm oder 300 mm, und wobei die erste Klebeoberfläche (3) und die zweite Klebeoberfläche (4) jeweils vollständig durch eine durchgehende hydrophile Folie (5) aus Siliziumoxid gebildet sind,
wobei der Schritt c) das Anordnen der im Schritt b) erhaltenen Direktklebeschnittstelle (6) in der basischen Umgebung für eine Dauer umfasst, die zwischen 21 und 40 Tagen liegt, wobei die basische Umgebung eine wässrige basische Lösung (8) ist, die durch Auflösen von NaOH gebildet ist, und eine Molkonzentration aufweist, die zwischen 10⁻⁷ Mol/l und 0,01 Mol/l liegt, und beispielsweise eine Molkonzentration von 10⁻³ Mol/l, und
der Schritt d) das Anwenden einer Wärmebehandlung bei etwa 300°C umfasst, um eine Direktverklebung zwischen dem ersten Substrat (1) und dem zweiten Substrat (2) zu erhalten, die eine Klebeenergie von mehr als 5 J/m² aufweist.

## Claims

1. A method for manufacturing a multilayer structure (100) by direct bonding between a first substrate (1) and a second substrate (2), the method comprising the steps of:
a) providing a first substrate (1) and a second substrate (2) respectively comprising a first bonding surface (3) and a second bonding surface (4),
b) bringing the first bonding surface (3) and the second bonding surface (4) into contact so as to create a direct bonding interface (6) between the first substrate (1) and the second substrate (2),
c) disposing at least the direct bonding interface (6) in a basic environment, and
d) applying a thermal treatment at a temperature of between 20°C and 1000°C so as to obtain the multilayer structure (100).

2. The manufacturing method according to claim 1, wherein step c) of disposing the direct bonding interface (6) in the basic environment is carried out for a duration of approximately 1 hour to 80 days.

3. The manufacturing method according to claim 1 or 2, wherein the first bonding surface (3) and/or the second bonding surface (4) are/is formed at least in part by a hydrophilic film (5) made of a material chosen from a native oxide, a thermal or deposited silicon oxide, a silicon nitride, a copper oxide and a combination of these materials.

4. The manufacturing method according to any of claims 1 to 3, wherein the first bonding surface (3) and the second bonding surface (4) are completely flat.

5. The manufacturing method according to any of claims 1 to 4, wherein the basic environment is an aqueous basic solution (8).

6. The manufacturing method according to claim 5, wherein the aqueous basic solution (8) is formed, by dissolving in deionized water, a basic compound chosen from NaOH, KOH, Na₂CO₃, NH₄OH, an amino alcohol and an mixture of these basic compounds; the amino alcohol being selected notably from 2-(dimethylamino)ethanol DMAE, N,N-diethyl-2-amino-ethanol, monoethanolamine, N-methyldiethanolamine, aminomethanol, N-methylhydroxylamine, diethanolamine, dimethanolamine, triethanolamine, trimethanolamine and a mixture of these amino alcohols.

7. The manufacturing method according to claim 5 or 6, wherein the aqueous basic solution (8) has a molar concentration of between 10⁻⁷ mol/l and 5 mol/l, notably between 10⁻⁻⁶ mol/l and 1 mol/l and in particular between 0.01 mol/l and 0.5 mol/l of basic compound.

8. The manufacturing method according to any of claims 1 to 4, wherein the basic environment is an atmosphere saturated with basic molecules in the vapor phase (8'), by evaporation in a hermetic enclosure (9) of a basic stock solution (11) comprising deionized water and a basic compound chosen from N,N-diethylethanolamine, dimethylaminoethanol, aminoethanol, N-methyldiethanolamine, aminomethanol, N-methylhydroxylamine, diethanolamine, dimethanolamine, triethanolamine, trimethanolamine, ethalonamine, diethyl-N-N-ethanol, ammonia and their combination.

9. The manufacturing method according to any of claims 1 to 8, wherein the first substrate (1) and the second substrate (2) are each formed by a material chosen from semiconductors, such as Si, Ge, InP, AsGa, SiC and GaN; the LNO, the LTO and their combination.

10. The manufacturing method according to any of claims 1 to 9, wherein:
the first substrate (1) and the second substrate (2) provided in step a) each comprise a silicon substrate having a diameter of between 25 mm and 300 mm, in particular 200 mm or 300 mm, and in which the first bonding surface (3) and the second bonding surface (4) are each completely formed by a continuous hydrophilic film (5) made of silicon oxide,
step c) comprises disposing the direct bonding interface (6), obtained in step b), in the basic environment over a duration of between 21 and 40 days, the basic environment being an aqueous basic solution (8) formed by dissolution of NaOH and having a molar concentration of between 10⁻⁷ mol/l and 0.01 mol/l and for example a molar concentration of approximately 10⁻³ mol/l, and
step d) comprises applying a thermal treatment at approximately 300°C, so as to obtain a direct bonding between the first substrate (1) and the second substrate (2) having a bonding energy greater than 5 J/m².
